(19) Europäisches Patentamt

European Patent Office

Office européen des brevets

(11) EP 0 721 670 B1

(12) FASCICULE DE BREVET EUROPEEN

(45) Date de publication et mention de la délivrance du brevet:
**03.12.1997 Bulletin 1997/49**

(21) Numéro de dépôt: **94928919.3**

(22) Date de dépôt: **27.09.1994**

(51) Int Cl.⁶: **H01L 43/08**, G01R 33/09

(86) Numéro de dépôt international:
**PCT/FR94/01128**

(87) Numéro de publication internationale:
**WO 95/09447 (06.04.1995 Gazette 1995/15)**

(54) **CAPTEUR DE COURANT COMPRENANT UN RUBAN MAGNETORESISTIF ET SON PROCEDE DE REALISATION**

MAGNETORESISTIVER STROMSENSOR UND VERFAHREN ZU SEINER HERSTELLUNG

CURRENT SENSOR COMPRISING A MAGNETORESISTIVE STRIP AND METHOD OF PRODUCTION

(84) Etats contractants désignés:
**DE GB IT**

(30) Priorité: **27.09.1993 FR 9311442**

(43) Date de publication de la demande:
**17.07.1996 Bulletin 1996/29**

(73) Titulaire: **COMMISSARIAT A L'ENERGIE ATOMIQUE**
**75015 Paris (FR)**

(72) Inventeurs:
• **MOUCHOT, Jean**
  **F-38000 Grenoble (FR)**
• **FEDELI, Jean-Marc**
  **F-38140 Beaucroissant (FR)**
• **BOILEAU, Franck**
  **F-38410 Uriage (FR)**

• **MAS, Patrick**
  **F-38600 Fontaine (FR)**

(74) Mandataire: **Dubois-Chabert, Guy et al**
**c/o BREVATOME**
**25, rue de Ponthieu**
**75008 Paris (FR)**

(56) Documents cités:
EP-A- 0 300 635          EP-A- 0 381 541
EP-A- 0 490 327

• PATENT ABSTRACTS OF JAPAN vol. 9, no. 156 (P-368) 29 Juin 1985 & JP,A,60 031 014 (SANYO DENKI KK.) 16 Février 1985
• PATENT ABSTRACTS OF JAPAN vol. 13, no. 280 (E-779) (3628) 27 Juin 1989 & JP,A,01 067 987 (SUMITOMO SPECIAL METALS CO LTD) 14 Mars 1989

## Description

La présente invention concerne un capteur de courant comprenant un ruban magnétorésistif et son procédé de réalisation. Ce capteur est destiné à la mesure des courants transportés par des conducteurs électriques. Il peut être employé pour la fabrication d'ampèremètres, pour la détection de courants de seuil (minima ou maxima), pour la détection des pertes de courant par mesure différentielle entre deux capteurs réalisés selon l'invention.

Parmi les capteurs de courant, certains permettent la mesure du courant passant dans un circuit sans avoir à insérer un dispositif dans le circuit lui-même. Ils ont l'avantage de ne pas modifier les montages électriques existants. Leur principe de fonctionnement repose sur la détection des champs magnétiques créés par le passage des courants dans les conducteurs.

On connaît des capteurs de courant de ce type qui utilisent l'effet magnétorésistif présenté par certains matériaux pour évaluer la valeur du courant passant dans un conducteur par l'intermédiaire du champ magnétique environnant ce conducteur et généré par ce courant.

Un matériau présente un effet magnétorésistif dès lors que sa résistivité varie en présence d'un champ magnétique. Cette variation se présente en général comme une décroissance de la résistivité depuis une valeur maximale correspondant à une absence de champ magnétique appliqué jusqu'à une valeur minimale correspondant à un champ magnétique de saturation pour ce matériau. La résistivité du matériau ne varie plus au-delà du champ magnétique de saturation. La zone de décroissance de la résistivité offre donc la possibilité de mesurer des courants électriques.

Les documents US-A-4 937 521 et DE-A-3 929 452 divulguent des capteurs de courant utilisant l'effet magnétorésistif. Le composant magnétorésistif utilisé est constitué d'une couche unique et est du type ferromagnétique. Il est généralement composé à partir d'alliages de métaux de transition (fer, nickel, cobalt). Ce composant présente un effet magnétorésistif anisotrope qui dépend de l'angle existant entre la direction de l'aimantation du matériau et la direction du courant que l'on fait circuler dans le composant magnétorésistif. Un composant magnétorésistif ayant la forme d'un barreau voit généralement son aimantation s'aligner parallèlement à la longueur de ce barreau. La résistivité de ces composants est alors insensible aux champs magnétiques appliqués selon cette même direction. Ces composants sont donc a effet magnétorésistif anisotrope. Les composants magnétorésistifs des capteurs de courant de l'art connu doivent donc être conçus en conséquence.

Ainsi, le composant magnétorésistif du document US-A-4 937 521 possède une forme en lacet. Ce composant est représenté à la figure 1 ci-jointe. Le composant magnétorésistif 1 est déposé sur un substrat isolant rigide 2 percé d'un trou central 3, le composant 1 se trouvant autour du trou central. Ses extrémités sont connectées à deux contacts 4 et 5 permettant son raccordement à un circuit extérieur qui comprend une alimentation et un dispositif de mesure décelant les variations de résistivité du composant 1. Le trou central 3 est destiné au passage du conducteur dont on veut mesurer le courant qui le parcourt. Un courant $I_1$ induit un champ magnétique $H_1$. Seules les parties du composant 1 transverses au champ $H_1$ verront leur résistivité modifiée par la présence du champ $H_1$. Les parties du composant 1 parallèles au champ $H_1$ ne verront pas leur résistivité modifiée.

Le composant magnétorésistif du document DE-A-3 929 452 est basé sur une géométrie comparable à celle du document précédent. Les parties électriques parallèles au champ magnétique sont réalisées en matériau bon conducteur non magnétique. Les parties transverses au champ magnétique sont réalisées en matériau magnétorésistif et sont partiellement recouvertes d'un ensemble de micro-languettes conductrices orientées à 45° de l'axe du composant magnétorésistif.

Les composants magnétorésistifs de l'art connu présentent donc l'inconvénient qu'une partie seulement de leur structure met en oeuvre l'effet magnétorésistif. Par ailleurs, ils sont réalisés sur des supports rigides limitant une réalisation collective des capteurs.

Dans un domaine tout à fait différent de celui de la présente invention et qui est celui de l'enregistrement magnétique de données, on utilise des composants magnétorésistifs connus sous le nom de structures magnétiques multicouches métalliques (SMMM).

Les SMMM connues sont formées d'un empilement de couches métalliques magnétiques séparées par des couches métalliques non-magnétiques, dans lesquelles l'épaisseur des couches non-magnétiques est telle qu'un couplage anti-ferromagnétique s'établit entre les couches magnétiques. Sous l'effet d'un champ magnétique appliqué à la structure, la rotation de l'état anti-parallèle à l'état parallèle des aimantations de chacune des couches magnétiques s'accompagne d'une diminution de la résistance électrique de la structure : c'est l'effet magnétorésistif.

Les documents EP-A-442 407, FR-A-2 648 942 et US-A-4 949 039 décrivent des exemples d'application de ces SMMM à l'enregistrement magnétique de données.

Des effets magnétorésistifs très importants ont été observés dans les structures suivantes : Fe/Cr, Co/Cr, Fe/Cu, Co/Cu, Co/Ag. Ces observations sont rapportées dans les articles suivants :

- "Giant Magnetoresistance : A Primer" de Robert L. White, paru dans IEEE Transactions on Magnetics, Vol. 28, No 5, Septembre 1992, p. 2482,

- "Magnetoresistance of Multilayers" de H. Yamamoto et T. Shinjo, paru dans IEEE Translation Journal on Magnetics in Japan, Vol. 7, No. 9, Septembre 1992, p. 674-684.

Peu de ces structures présentent une sensibilité élevée associée à une hystérésis quasi-nulle (critère déterminant la réversibilité magnétique). A ce jour, seules les structures FeNi/Cu et FeNi/Ag répondent maintenant à ces deux critères. Ces structures ont fait l'objet des articles suivants :

- "Oscillations in Giant Magnetoresistance and Antiferromagnetic Coupling in $[Ni_{81}Fe_{19}/Cu]_N$ Multilayers" de S.S.P. Parkin, paru dans Appl. Phys. Lett. 60(4), 27 Janvier 1992, p. 512-514,
- "Magnetoresistive Properties and Thermal Stability of Ni-Fe/Ag Multilayers" de B. Rodmacq, G. Palumbo et Ph. Gerard, paru dans Journal of Magnetism and Magnetic Materials, 118 (1993), L11-L16.

Pour remédier aux inconvénients présentés par les capteurs de courant à composant magnétorésistif selon l'art connu (faible effet magnétorésistif et effet magnétorésistif anisotrope), la présente invention propose d'utiliser à la place des composants magnétorésistifs monocouches utilisés classiquement, des composants magnétorésistifs multicouches.

Cependant, les SMMM ne présentent pas les mêmes caractéristiques magnétiques (notamment un effet magnétorésistif isotrope) que les magnétorésistances monocouches, l'invention propose une nouvelle géométrie de magnétorésistance tenant compte de ces caractéristiques pour les utiliser au mieux dans l'application capteur de courant. Par ailleurs, ces SMMM sont réalisées avantageusement sur des substrats aptes à être déformés de façon a pouvoir être enroulés autour de conducteurs électriques. Dans ce cas, les SMMM sont dans un plan perpendiculaire à celui des magnétorésistances des capteurs de l'art antérieur. Cette géométrie favorise une réalisation collective des capteurs.

Bien entendu, l'utilisation de SMMM sur un substrat rigide disposé selon le même plan que celui de l'art antérieur ne sort pas du cadre de l'invention.

La fabrication des capteurs selon l'invention peut avantageusement se faire au moyen des micro-technologies.

Par rapport aux monocouches ferromagnétiques réalisées à partir d'alliages de métaux de transition, les structures multicouches ont donc l'avantage de posséder un effet magnétorésistif isotrope qui ne tient pour ainsi dire pas compte de l'angle existant entre la direction d'application du champ magnétique et la direction prise par le courant que l'on fait circuler dans le composant magnétorésistif dès lors que ne sont pas considérés les effets de champ démagnétisant associés à la géométrie du composant. Il est ainsi possible d'appliquer le champ magnétique correspondant à un courant à mesurer dans une direction parallèle à celle du courant dans le composant magnétorésistif et d'obtenir une variation de la résistivité intrinsèque de la structure multicouche.

L'invention a donc pour objet un capteur de courant destiné à mesurer le courant parcourant un conducteur électrique, comprenant un ruban magnétorésistif entourant le conducteur et dont les extrémités sont destinées à être connectées à un dispositif de mesure du courant, caractérisé en ce que le ruban a une forme de tube d'axe centré sur le conducteur et en ce qu'il est constitué en structure magnétique multicouche métallique dont les couches constituent autant de tubes élémentaires empilés concentriques audit axe.

Le ruban peut avantageusement comprendre des moyens de polarisation magnétique de la structure magnétique multicouche métallique. La polarisation de la magnétorésistance au moyen d'un champ magnétique permanent permet de connaître le signe du champ magnétique induit par le courant à mesurer et par conséquent le sens du courant.

Le ruban peut être formé d'une suite d'éléments de structure magnétique multicouche métallique, deux éléments successifs de la suite étant reliés électriquement entre eux par des éléments magnétiques conducteurs constituant lesdits moyens de polarisation magnétique.

Le ruban peut aussi être formé d'une suite d'éléments de structure magnétique multicouche métallique, deux éléments successifs de la suite étant reliés électriquement entre eux par des éléments conducteurs supportant des éléments magnétiques constituant lesdits moyens de polarisation magnétique.

Les éléments magnétiques constituant les moyens de polarisation sont avantageusement réalisés en matériau magnétique dur, c'est-à-dire présentant une coercivité élevée.

L'invention a aussi pour objet un procédé de réalisation d'un capteur de courant comprenant un ruban magnétorésistif pourvu d'extrémités destinés à être connectées à un dispositif de mesure du courant, caractérisé en ce qu'il comprend les étapes suivantes :

- dépôt sur une face d'un substrat isolant d'une couche métallique conductrice,
- gravure de la couche métallique conductrice pour constituer les extrémités du ruban,
- dépôt d'une couche de matériau magnétique conducteur sur ladite face,
- gravure de ladite couche de matériau magnétique conducteur pour obtenir une suite d'éléments magnétiques conducteurs, alignés et séparés les uns des autres, entre lesdites extrémités,

- dépôt sur ladite face d'une couche en structure magnétique multicouche métallique,
- gravure de ladite couche en structure magnétique multicouche métallique pour obtenir des éléments uniquement entre les éléments magnétiques et pour assurer la continuité électrique entre lesdites extrémités.

L'invention a encore pour objet un procédé de réalisation d'un capteur de courant comprenant un ruban magnétorésistif pourvu d'extrémités destinées à être connectées à un dispositif de mesure du courant, caractérisé en ce qu'il comprend les étapes suivantes :

- dépôt sur une face d'un substrat isolant d'une couche métallique conductrice,
- gravure de la couche métallique conductrice pour constituer les extrémités du ruban et une suite d'éléments conducteurs, alignés et séparés les uns des autres, entre lesdites extrémités,
- dépôt d'une couche de matériau magnétique sur ladite face,
- gravure de ladite couche de matériau magnétique pour obtenir une suite d'éléments magnétiques reposant sur les éléments conducteurs,
- dépôt sur ladite face d'une couche en structure magnétique multicouche métallique,
- gravure de ladite couche en structure magnétique multicouche métallique pour obtenir des éléments uniquement entre les éléments conducteurs et pour assurer la continuité électrique entre lesdites extrémités.

L'invention sera mieux comprise et d'autres avantages et particularités apparaîtront à la lecture de la description qui va suivre, donnée à titre d'exemple non limitatif, accompagnée des dessins annexés parmi lesquels :

- la figure 1 représente un composant magnétorésistif d'un capteur de courant selon l'art connu,
- la figure 2 représente un capteur de courant selon l'invention,
- la figure 3 représente de façon sommaire un circuit électrique associé au capteur de courant selon l'invention et permettant la mesure du courant parcourant un conducteur,
- la figure 4 représente schématiquement, en coupe longitudinale, une partie d'un ruban magnétorésistif utilisable par un capteur de courant selon l'invention,
- la figure 5 représente, en première variante et en coupe longitudinale, une partie d'un ruban magnétorésistif à polarisation magnétique de la magnétorésistance selon l'invention,
- les figures 6 et 7 sont des diagrammes explicatifs, respectivement pour un ruban magnétorésistif non polarisé magnétiquement et pour un ruban magnétorésistif polarisé magnétiquement,
- la figure 8 représente, en seconde variante et en coupe longitudinale, une partie d'un ruban magnétorésistif à polarisation magnétique de la magnétorésistance selon l'invention,
- la figure 9 représente un diagramme explicatif pour un ruban magnétorésistif polarisé de manière particulière,
- la figure 10 illustre un mode de réalisation possible, de manière collective, de capteurs de courant selon l'invention,
- la figure 11 représente un capteur de courant selon l'invention,
- la figure 12 représente un autre mode de réalisation possible, de manière collective, de capteurs de courant selon l'invention.

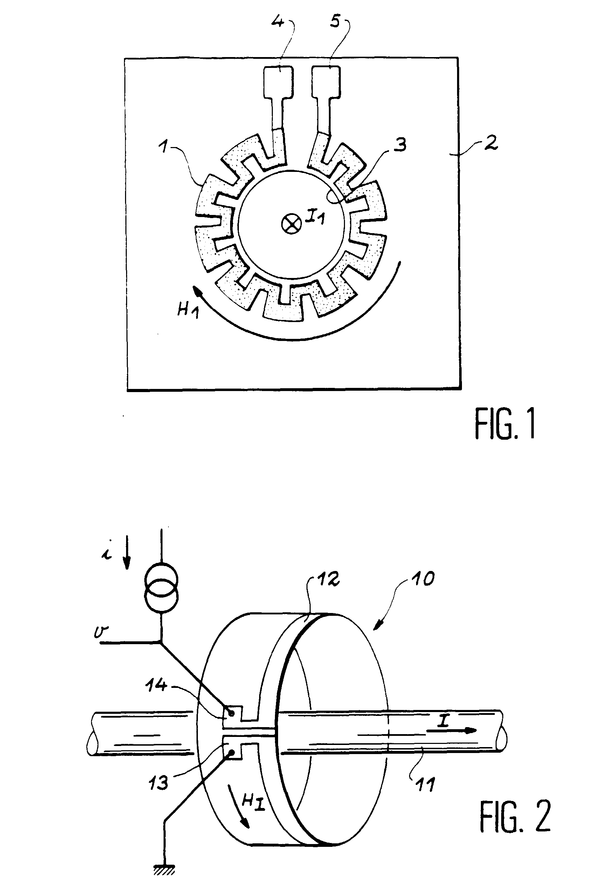

La figure 2 représente un capteur de courant 10 selon l'invention en position de mesure du courant I parcourant le conducteur électrique 11. Le capteur de courant 10 en forme d'anneau comporte un ruban magnétorésistif 12 également en forme d'anneau. Les extrémités 13 et 14 du ruban 12 sont disposées à proximité l'une de l'autre de façon que le ruban forme un cercle presque complet. Ces extrémités sont aménagées pour permettre la connexion électrique du ruban 12 avec un générateur de courant continu i (ou de tension). L'observation de la tension v aux bornes au ruban 12 permet de constater la variation de la résistance du ruban sous l'effet du champ magnétique $H_I$ induit par le courant I.

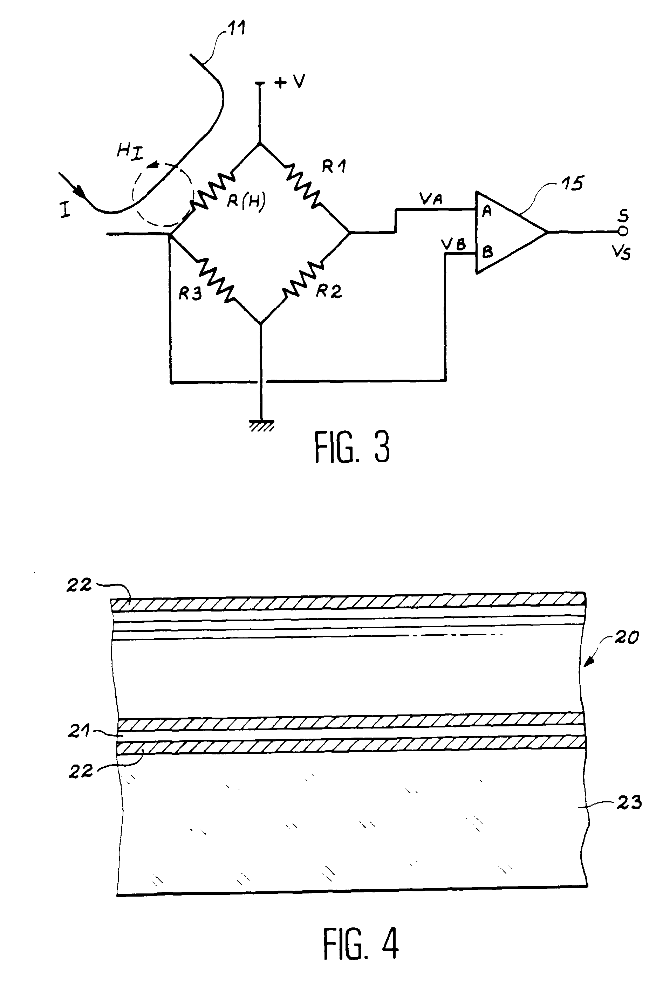

La figure 3 représente de façon sommaire un exemple de circuit électrique permettant la mesure du courant I parcourant le conducteur 11. Le ruban magnétorésistif, représenté schématiquement par sa résistance R(H) est intégré dans un pont de Wheatstone comportant les autres résistances $R_1$, $R_2$ et $R_3$. Le pont est alimenté par une tension V. La sortie du pont est reliée à l'entrée d'un amplificateur différentiel 15. En choisissant les valeurs de $R_1$ et $R_2$, on peut fixer la valeur du potentiel à l'entrée A de l'amplificateur 15. Les variations de R(H) sont répercutées sur le potentiel obtenu à l'entrée B de l'amplificateur 15, $R_3$ étant également choisie. Cet amplificateur délivre un signal de sortie en S proportionnel à la différence de potentiel vue à ses entrées, donc proportionnel au courant I.

L'homme du métier connaît d'autres circuits électriques de mesure que celui illustré par la figure 3, en particulier ceux décrits dans le brevet US-A-4 937 521.

Le capteur de courant peut être réalisé en utilisant les techniques de la microtechnologie. Il peut être réalisé à partir d'un substrat plat que l'on enroule ou que l'on colle sur un support circulaire afin d'entourer le conducteur. Le substrat doit donc dans ce cas être apte à être déformé. Il peut être constitué à partir d'une feuille ou d'un clinquant d'acier, d'inox et recouvert d'un film isolant électrique. On peut également utiliser un matériau plastique du genre PVC, polyuréthane ou polyester. On peut encore utiliser un polyimide. Typiquement, l'épaisseur du substrat sera comprise entre 10 et 100 μm.

Le ruban magnétorésistif peut être constitué, comme représenté sur la figure 4, d'un empilement 20 de couches magnétiques 21 séparées par des couches non magnétiques métalliques 22 sur un substrat 23.

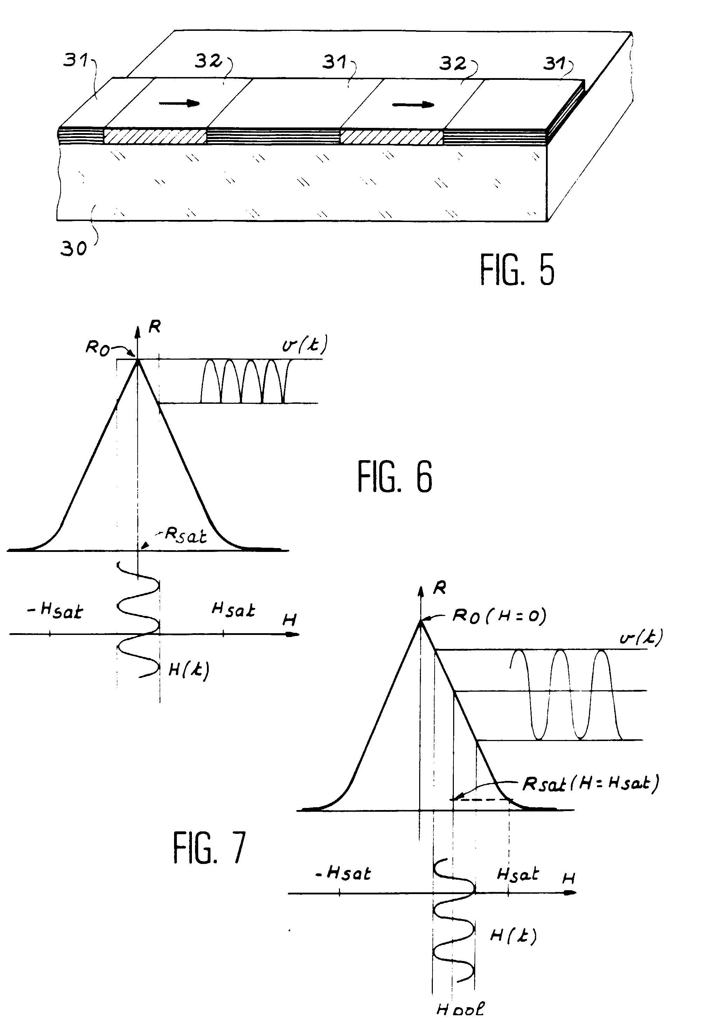

La variante représentée à la figure 5 a été réalisée à partir d'un substrat isolant 30 sur lequel on a déposé un ruban magnétorésistif constitué d'une alternance d'éléments 31 à structure magnétique multicouche métallique (SMMM) et d'éléments magnétiques conducteurs 32. Les éléments magnétiques conducteurs 32 permettent de relier électriquement les éléments SMMM 31. Ils sont avantageusement réalisés en matériau magnétique dur. La résistance électrique de ce composant magnétorésistif est la somme des résistances des éléments SMMM 31 et des éléments conducteurs 32. On comprend que les éléments conducteurs 32 augmentent la résistance totale du composant magnétorésistif et diminuent son effet magnétorésistif puisque leur résistivité ne varie pas en fonction du champ magnétique appliqué. On a donc intérêt à minimiser la résistance des éléments conducteurs 32, par exemple en augmentant leur section (largeur et épaisseur).

En orientant l'aimantation de chacun des éléments magnétiques conducteurs 32 dans une même direction, il en résulte un champ magnétique de polarisation au sein des éléments SMMM 31. Ceci présente l'avantage de permettre de connaître le signe du courant I à mesurer comme on va l'expliquer à l'aide des figures 6 et 7.

Les diagrammes des figures 6 et 7 représentent l'évolution de la tension v aux bornes du ruban magnétorésistif en fonction du champ magnétique H induit par un courant alternatif parcourant le conducteur autour duquel est placé le capteur de courant. Le ruban magnétorésistif est parcouru par un courant continu i d'amplitude constante délivré par un générateur de courant. Sur les figures 6 et 7, on a représenté la courbe R montrant l'évolution de la résistance du ruban magnétorésistif en fonction du champ magnétique H appliqué. La résistance varie d'une valeur maximale $R_o$ pour $H = 0$ jusqu'à une valeur minimale $R_{sat}$ pour des champs magnétiques égaux ou supérieurs, en valeur absolue, au champ de saturation $H_{sat}$. La tension $v = R.i$ recueillie aux bornes du ruban magnétorésistif variera donc en relation avec la courbe R.

La figure 6 se rapporte au cas d'un ruban magnétorésistif non polarisé magnétiquement. Si le conducteur, dont on veut mesurer le courant qui y circule, est parcouru par un courant alternatif, il induira autour de lui un champ magnétique également alternatif. Le ruban magnétorésistif sera donc soumis à un champ magnétique H(t) tel que celui représenté à la figure 6. La tension v recueillie variera donc entre une valeur maximale $R_o.i$ (pour H= 0) et une valeur minimale correspondant à une amplitude maximale d'une alternance positive ou négative de H(t). En l'absence de polarisation magnétique, une magnétorésistance double la fréquence d'oscillation de l'excitation magnétique. Il n'est alors pas possible de déterminer le signe de H et donc le signe du courant I à mesurer.

La figure 7 se rapporte au cas d'un ruban magnétorésistif polarisé magnétiquement par un champ permanent $H_{pol}$ tel que celui produit par les éléments magnétiques 32 (voir la figure 5). Dans ce cas, le signal mesuré est de même période que l'excitation magnétique et le signe de H (donc le sens du courant) peut être connu.

En choisissant des éléments magnétiques à forte coercitivité (en matériau dur) on peut, après les avoir placés dans un champ magnétique intense (supérieur à leur champ coercitif, orienter l'aimantation parallèlement à la longueur du ruban. Du fait de leur emplacement, les éléments magnétiques génèrent donc un champ de polarisation au sein des éléments SMMM parallèle à la longueur du ruban.

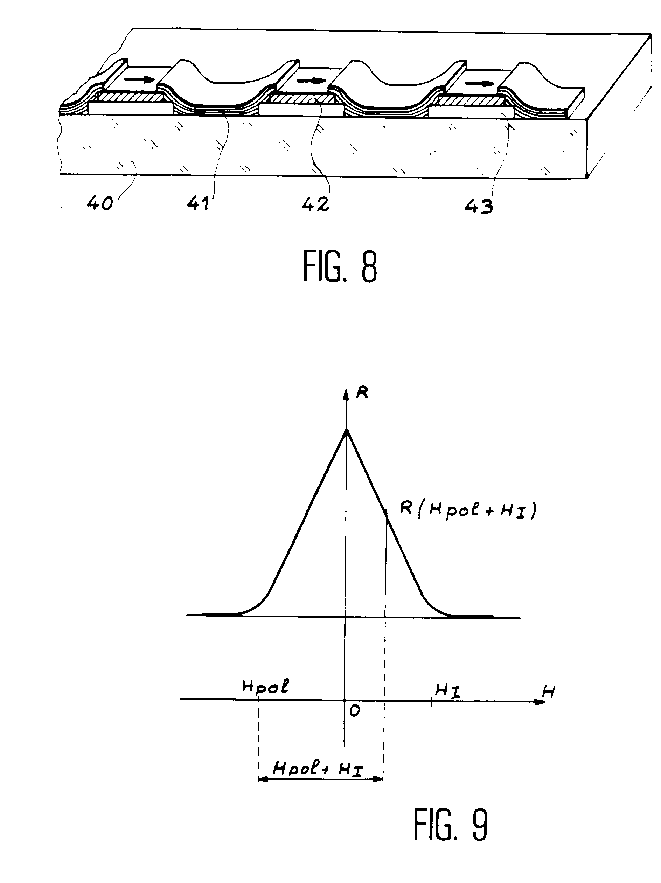

La variante représentée à la figure 8 diffère de celle de la figure 5 en ce que, entre les éléments SMMM 41 déposés sur le substrat isolant 40, on a déposé des éléments conducteurs non magnétiques 43 supportant des éléments magnétiques 42 qui peuvent être de ce fait non conducteur ou mauvais conducteur. Cette solution présente plusieurs avantages par rapport à la précédente. Elle permet d'assurer la liaison électrique entre les éléments SMMM de la meilleure façon possible. En effet, les matériaux les plus conducteurs (tels que le cuivre, l'argent) n'étant pas magnétiques ne pouvaient pas être employés dans le cas de la variante illustrée par la figure 5. Ils peuvent être utilisés dans le cas présent. Par ailleurs, les éléments 42 sont également avantageusement réalisés à partir de matériau magnétique dur.

L'utilisation d'éléments magnétiques en matériau particulièrement dur peut être utile pour la mesure de courants importants. En effet, en présence de courants importants (I>1000 A), l'excitation magnétique $H_I$ peut devenir proche et même supérieure au champ à saturation $H_{sat}$ de la magnétorésistance. Il est alors avantageux d'orienter l'aimantation des éléments magnétiques dans la direction opposée à celle du champ magnétique appliqué au ruban magnétorésistif. Ceci est valable notamment dans le cas de courants continu ou à faible variation autour de leur valeur nominale. C'est ce qu'illustre la figure 9 qui représente un diagramme ayant en ordonnées la valeur R du ruban magnétorésistif et en abscisses la valeur du champ magnétique H appliqué. Le champ magnétique de polarisation $H_{pol}$ étant négatif, on peut ainsi mesurer correctement des courants I induisant un champ magnétique $H_I$ de valeur telle qu'en absence de champ magnétique de polarisation cette mesure n'aurait pas pu être faite. Il faut cependant s'assurer que les champs magnétiques $H_{pol}$, $H_I$ et $H_{pol} + H_I$ sont bien inférieurs au champ coercitif des éléments magnétiques durs. On évite ainsi tout risque de désaimantation progressive des éléments magnétiques.

Pratiquement, il faudrait vérifier que $H_l < H_c/10$ ou $H_c$ est le champ coercitif. Autour de $R(H_{pol} + H_l)$, on peut mesurer la résistance de R(H) et déterminer ainsi la valeur du courant. On peut définir une résistance minimale $R_{min}$ et une résistance maximale $R_{max}$ correspondant à des champs magnétiques $H_{min}$ et $H_{max}$ au-delà desquels le courant à mesurer est jugé trop fort ou trop faible respectivement.

Si on choisit un champ $H_{pol}$ opposé mais en valeur absolue égal au champ $H_l$ induit par un courant I déterminé, toute diminution de résistance correspond à un fonctionnement anormal (surintensité ou sous-intensité). On peut réaliser ainsi l'élément essentiel d'un disjoncteur.

L'ensemble des éléments conducteurs magnétiques ou non (voir figures 5 et 8) doit présenter une résistance la plus faible possible. On doit donc minimiser leur longueur et choisir un matériau bon conducteur, c'est-à-dire que sa résistivité doit être faible devant celle du matériau SMMM. L'épaisseur des éléments conducteurs doit être la plus grande possible sans toutefois gêner l'empilement technologique dans le cas de la variante représentée à la figure 8. On peut typiquement choisir une épaisseur du matériau conducteur entre 0,1 et 3 μm. Ce matériau conducteur peut être du cuivre ou de l'or avec une sous-couche d'accrochage en tungstène, en chrome, en tantale, etc.

On choisira de préférence une structure multicouche magnétique métallique de magnétorésistance élevée. Suivant l'intensité des courants à mesurer, le champ à saturation devra être plus ou moins important s'il est possible de le choisir. Par exemple, si l'on souhaite mesurer des courants dans une gamme allant jusqu'à 100 A à partir d'un élément magnétorésistif enroulé sur un support de manière à former un dispositif d'un diamètre égal à 1 cm, on cherchera une structure multicouche magnétique métallique ayant un champ à saturation au moins égal à 3,5 kA/m. La longueur, la largeur et l'épaisseur des éléments magnétorésistifs doivent être choisies de manière à obtenir une résistance relativement élevée par rapport à celle des éléments conducteurs. Typiquement, la résistance du ruban devrait être comprise entre 100 $\Omega$ et 100 k$\Omega$ et de préférence entre 1 k$\Omega$ et 10 k$\Omega$. Ainsi, l'alimentation du ruban magnétorésistif pourra être faite à partir d'un générateur de courant (ou de tension) commercialisé couramment.

Le choix des longueurs des éléments SMMM et des éléments conducteurs est guidé par le champ de polarisation que l'on veut imposer dans les éléments SMMM, et par la minimisation de la résistance électrique des éléments conducteurs.

Plus la coercivité de ce matériau magnétique est élevée, plus les risques de désaimantation progressive sont diminués. Pour des champs magnétiques à mesurer de l'ordre de 4 kA/m, il est bon d'employer un matériau magnétique vérifiant la relation $H_c > 40$ kA/m par exemple.

Les dimensions des éléments magnétiques de polarisation et la distance qui les sépare les uns des autres doivent être telles que le champ de polarisation qu'ils induisent soit égal à celui recherché. Les éléments conducteurs sous-jacents aux éléments magnétiques ont au moins la même longueur que les éléments magnétiques. Ces paramètres géométriques dépendent bien sûr de la valeur de l'aimantation rémanente du matériau magnétique dur et de la perméabilité magnétique des éléments SMMM. Plus cette perméabilité est élevée, plus nombreuses sont les lignes de flux magnétique captées par la magnétorésistance et plus élevé sera donc le champ magnétique de polarisation.

On va maintenant montrer comment on peut déterminer la valeur du courant I circulant dans un conducteur autour duquel est enroulé circulairement le ruban magnétorésistif selon l'invention. Le champ magnétique H circulant dans le ruban magnétorésistif enroulé circulairement est défini par la relation H = I/L où L est la longueur du ruban. Le calcul sera fait pour le cas le plus compliqué, c'est-à-dire lorsque le ruban magnétorésistif est du type représenté à la figure 8.

Le ruban magnétorésistif a pour résistance

$$R(H) = R_{cond} + R_{mult}(H)$$

où $R_{cond}$ représente la résistance des éléments conducteurs 43 et $R_{mult}(H)$ représente la résistance des éléments SMMM 41 qui dépend du champ magnétique H appliqué. Si l'on considère que la courbe de magnétorésistance est linéaire entre H = 0, pour lequel $R_{mult} = R_{mult}(H=0)$, et $H = H_{sat}$ ou $-H_{sat}$, pour lequel $R_{mult} = R_{mult}(H=H_{sat})$, on obtient pour $H < H_{sat}$ :

$$R(H) = R_{cond} + R_{mult}(H=0)\left[1 - \frac{\Delta R}{R_{mult}(H=0)} \times \frac{H}{H_{sat}}\right]$$

avec $\Delta R = R(H=0) - R(H=H_{sat})$.

Pour $H > H_{sat}$, on a la relation :

$$R(H) = R_{cond} + R_{mult}(H=H_{sat}).$$

Pour un circuit de mesure tel que celui représenté à la figure 3, les tensions $V_A$ et $V_B$ sont les suivantes :

$$V_A = \frac{R_2}{R_1+R_2} \times V \qquad V_B = \frac{R_3}{R_3+R(H)} \times V$$

d'où :

$$V_A\text{-}V_B = \frac{R_2 \cdot R(H)\text{-}R_3 \cdot R_1}{(R_1+R_2)(R_3+R(H))} \times V$$

En choisissant $R_1$, $R_2$ et $R_3$ de sorte que
$R_3 \cdot R_1 = R_2 \cdot R(H{=}0)$, on obtient :

$$V_A\text{-}V_B = - \frac{R_2 \times \Delta R}{(R_1+R_2)(R_3+R(H))} \times \frac{I}{H_{sat}} \times \frac{I}{L} \times V$$

En première approximation et si G est le gain de l'amplificateur 15, on obtient à la sortie S :

$$V_S = - \frac{R_2 \times \Delta R}{(R_1+R_2)(R_3+R(H{=}0))} \times \frac{G}{H_{sat}} \times \frac{I}{L} \times V$$

On en tire la valeur du courant I.

On va maintenant décrire la réalisation technologique d'un capteur de courant du type représenté à la figure 8.

Le substrat 40 est introduit dans une enceinte à vide pour le dépôt d'une couche de matériau conducteur. Cette couche est ensuite gravée pour former les éléments conducteurs 43 et les extrémités du ruban destinées à assurer les connexions au dispositif de mesure. On dépose alors une couche de matériau magnétique avantageusement dur qui est ensuite également gravée de manière à former les éléments magnétiques 42 sur les éléments conducteurs 43. On dépose ensuite une couche de matériau magnétique multicouche métallique par pulvérisation cathodique ou évaporation sous vide des cibles nécessaires à sa réalisation. On grave à nouveau pour obtenir les éléments SMMM 41. La structure obtenue peut être ensuite recouverte d'un film protecteur sous réserve de dégager les extrémités du ruban magnétorésistif pour assurer les connexions électriques. La structure ainsi réalisée est alors soumise à l'effet d'un champ magnétique intense pour orienter l'aimantation des éléments magnétiques 42 dans la direction désirée.

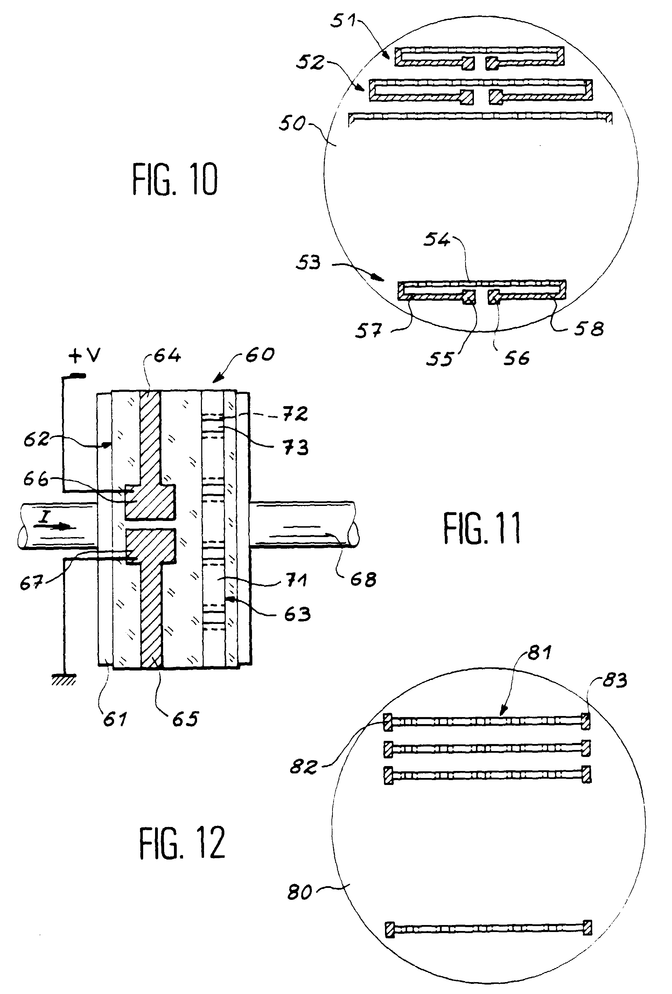

A partir d'un même substrat de forme circulaire, on peut ainsi élaborer un grand nombre de capteurs de courant. La figure 10 représente, vue de dessus, une telle réalisation. Le substrat 50 supporte un grand nombre de rubans magnétorésistifs selon l'invention. Les rubans 51, 52,...53 peuvent être de longueurs différentes. Dans cet exemple de réalisation, les parties actives des magnétorésistances, telles que la partie 54 du ruban 53, sont reliées aux extrémités des rubans, telles les extrémités 55 et 56 du ruban 53, par des liaisons réalisées à partir de la première couche conductrice déposée, telles les liaisons 57 et 58 du ruban 53.

Chaque ruban est ensuite découpé avec sa partie de substrat correspondante pour constituer une bande qui va être montée sur un support circulaire qui entourera le conducteur dont on veut mesurer le courant qui le parcourt. La figure 11 représente un capteur de courant 60 obtenu de cette façon. Le capteur 60 comprend un support circulaire 61 sur lequel est fixée, par exemple par collage, la bande 62. Cette bande comporte un ruban magnétorésistif 63 relié par des liaisons 64 et 65 à des extrémités 66 et 67. Le capteur de courant 60 est représenté sur la figure 11 en position de mesure autour du conducteur 68. On distingue, sur le ruban 63 les éléments SMMM 71 et les éléments conducteurs 72 sur lesquels sont déposés les éléments magnétiques 73.

Dans la vue de dessus de la figure 12, le substrat 80 supporte également un grand nombre de rubans magnétorésistifs 81 tous identiques. Dans cet exemple de réalisation, les rubans sont reliés directement aux extrémités 82 et 83 sans éléments de liaison. Cette conception permet de réduire au minimum la résistance des parties non magnétorésistives des rubans.

## Revendications

1. Capteur de courant (10) destiné à mesurer le courant parcourant un conducteur électrique (11), comprenant un ruban magnétorésistif (12) entourant le conducteur et dont les extrémités (13, 14) sont destinées à être connectées à un dispositif de mesure du courant, caractérisé en ce que le ruban a une forme de tube d'axe centré sur le conducteur et en ce qu'il est constitué en structure magnétique multicouche métallique dont les couches constituent autant de tubes élémentaires empilés, concentriques audit axe.

2. Capteur de courant selon la revendication 1, caractérisé en ce que le ruban comprend des moyens de polarisation magnétique de la structure magnétique multicouche métallique.

3. Capteur de courant selon la revendication 2, caractérisé en ce que le ruban comprend une suite d'éléments de structure magnétique multicouche métallique (31), deux éléments successifs de la suite étant reliés électriquement entre eux par des éléments magnétiques conducteurs (32) constituant lesdits moyens de polarisation magnétique.

4. Capteur de courant selon la revendication 2, caractérisé en ce que le ruban comprend une suite d'éléments de structure magnétique multicouche métallique (41), deux éléments successifs de la suite étant reliés électriquement entre eux par des éléments conducteurs (43) supportant des éléments magnétiques (42) constituant lesdits moyens de polarisation magnétique.

5. Capteur de courant selon la revendication 4, caractérisé en ce que, afin de réduire la résistance du ruban magnétorésistif due aux éléments conducteurs, la section de ces éléments conducteurs, considérée dans un plan perpendiculaire à la longueur du ruban, est supérieure à la section, considérée également dans un plan perpendiculaire à la longueur du ruban, des éléments en structure magnétique multicouche métallique.

6. Capteur de courant selon l'une quelconque des revendications 2 à 5, caractérisé en ce que lesdits moyens de polarisation magnétique sont réalisés à partir d'un matériau magnétique dur.

7. Capteur de courant selon l'une quelconque des revendications 1 à 6, caractérisé en ce qu'il est constitué d'un support circulaire (61) sur lequel est fixé le ruban magnétorésistif (63).

8. Procédé de réalisation d'un capteur de courant comprenant un ruban magnétorésistif pourvu d'extrémités destinées à être connectées à un dispositif de mesure du courant, caractérisé en ce qu'il comprend les étapes suivantes :

   - dépôt sur une face d'un substrat isolant (30) d'une couche métallique conductrice,
   - gravure de la couche métallique conductrice pour constituer les extrémités du ruban,
   - dépôt d'une couche de matériau magnétique conducteur sur ladite face,
   - gravure de ladite couche de matériau magnétique conducteur pour obtenir une suite d'éléments magnétiques conducteurs (32), alignés et séparés les uns des autres, entre lesdites extrémités,
   - dépôt sur ladite face d'une couche en structure magnétique multicouche métallique,
   - gravure de ladite couche en structure magnétique multicouche métallique pour obtenir des éléments (31) uniquement entre les éléments magnétiques (32) et pour assurer la continuité électrique entre lesdites extrémités.

9. Procédé de réalisation d'un capteur de courant comprenant un ruban magnétorésistif pourvu d'extrémités destinées à être connectées à un dispositif de mesure du courant, caractérisé en ce qu'il comprend les étapes suivantes :

   - dépôt sur une face d'un substrat isolant (40) d'une couche métallique conductrice,
   - gravure de la couche métallique conductrice pour constituer les extrémités du ruban et une suite d'éléments conducteurs (43), alignés et séparés les uns des autres, entre lesdites extrémités,
   - dépôt d'une couche de matériau magnétique sur ladite face,
   - gravure de ladite couche de matériau magnétique pour obtenir une suite d'éléments magnétiques (42) reposant sur les éléments conducteurs (43),
   - dépôt sur ladite face d'une couche en structure magnétique multicouche métallique,
   - gravure de ladite couche en structure magnétique multicouche métallique pour obtenir des éléments (41) uniquement entre les éléments conducteurs (43) et pour assurer la continuité électrique entre lesdites extrémités.

10. Procédé selon l'une des revendications 8 ou 9, caractérisé en ce que le substrat isolant (30) utilisé est apte à être déformé.

**Patentansprüche**

1. Stromsensor (10) zum Messen des einen elektrischen Leiter (11) durchfließenden Stroms, einen den Leiter umgebenden magnetoresistiven Streifen (12) umfassend, dessen Enden (13, 14) dazu bestimmt sind, mit einer Strommeßvorrichtung verbunden zu werden,
   **dadurch gekennzeichnet**,
   daß der Streifen die Form einer Röhre aufweist, deren Achse auf den Leiter zentriert ist, und dadurch, daß er gebildet wird durch eine metallische magnetische Mehrschichtenstruktur, deren Schichten ebensoviele aufeinandergeschichtete Elementarröhren bilden, konzentrisch zu der genannten Achse.

2. Stromsensor nach Anspruch 1, dadurch gekennzeichnet, daß der Streifen magnetische Polarisationseinrichtungen der metallischen magnetischen Mehrschichtstruktur umfaßt.

3. Stromsensor nach Anspruch 2, dadurch gekennzeichnet, daß der Streifen eine Reihenfolge metallischer magnetischer Mehrschichten-Strukturelemente (31) umfaßt, wobei zwei aufeinanderfolgende Elemente der Reihenfolge elektrisch miteinander verbunden sind durch leitende magnetische Elemente (32), welche die genannten magnetischen Polaristationseinrichtungen bilden.

4. Stromsensor nach Anspruch 2, dadurch gekennzeichnet, daß der Streifen eine Reihenfolge metallischen magnetischen Mehrschichten-Strukturelementen (41) umfaßt, wobei zwei aufeinanderfolgende Elemente der Reihenfolge elektrisch miteinander verbunden sind durch leitende magnetische Elemente (43), die magnetische Elemente (42) tragen, welche die genannten magnetischen Polaristationseinrichtungen bilden.

5. Stromsensor nach Anspruch 4, dadurch gekennzeichnet, daß, um den Widerstand des magnetoresitiven Streifens zu reduzieren, der Querschnitt dieser leitenden Elemente, betrachtet in einer zur Streifenlänge senkrechten Ebene, größer ist als der ebenfalls in einer zur Streifenlänge senkrechten Ebene betrachtete Querschnitt der metallischen magnetischen Mehrschichten-Strukturelemente.

6. Stromsensor nach einem der Ansprüche 2 bis 5, dadurch gekennzeichnet, daß die genannten magnetischen Polarisationselemente aus einem harten magnetischen Material hergestellt werden.

7. Stromsensor nach einem der Ansprüche 1 bis 6, dadurch gekennzeichnet, daß er durch einen kreisrunden Träger (61) gebildet wird, auf dem der magnetoresistive Streifen (63) befestigt ist.

8. Verfahren zur Herstellung eines Stromsensors, einen magnetoresistiven Streifen umfassend, versehen mit Enden, die dazu bestimmt sind, mit einer Strommeßvorrichtung verbunden zu werden,
   **dadurch gekennzeichnet**, daß es die folgenden Schritte umfaßt:

   - Abscheiden einer leitenden metallischen Schicht auf einer Seite bzw. Fläche eines isolierenden Substrats (30),
   - Ätzen der leitenden metallischen Schicht, um die Enden des Streifens zu bilden,
   - Abscheiden einer Schicht aus leitendem magnetischem Material auf der genannten Seite bzw. Fläche,
   - Ätzen der genannten Schicht aus leitendem magnetischem Material, um eine Reihenfolge leitender magnetische Elemente (32) herzustellen, fluchtend und voneinander getrennt, zwischen den genannten Enden,
   - Abscheiden einer Schicht mit metallischer magnetischer Mehrschichtenstruktur auf der genannten Seite bzw. Fläche,
   - Ätzen der genannten Schicht mit metallischer magnetischer Mehrschichtenstruktur, um Elemente (31) nur zwischen den magnetischen Elementen (32) herzustellen und um die elektrische Kontinuität zwischen den genannten Enden sicherzustellen.

9. Verfahren zur Herstellung eines Stromsensors, einen magnetoresistiven Streifen umfassend, versehen mit Enden, die dazu bestimmt sind, mit einer Strommeßvorrichtung verbunden zu werden,
   dadurch gekennzeichnet, daß es die folgenden Schritte umfaßt:

   - Abscheiden einer leitenden metallischen Schicht auf einer Seite bzw. Fläche eines isolierenden Substrats (40),
   - Ätzen der leitenden metallischen Schicht, um die Enden des Streifens und eine Reihenfolge von leitenden Elementen (43) zu bilden, fluchtend und voneinander getrennt, zwischen den genannten Enden,
- Abscheiden einer Schicht aus magnetischem Material auf der genannten Seite bzw. Fläche,
- Ätzen der genannten Schicht aus magnetischem Material, um eine Reihenfolge leitender magnetische Elemente (42) herzustellen, die auf den leitenden Elementen (43) ruhen,
- Abscheiden einer Schicht mit metallischer magnetischer Mehrschichtenstruktur auf der genannten Seite bzw. Fläche,
- Ätzen der genannten Schicht mit metallischer magnetischer Mehrschichtenstruktur, um Elemente (41) nur zwischen den magnetischen Elementen (43) herzustellen und um die elektrische Kontinuität zwischen den genannten Enden sicherzustellen.

**10.** Verfahren nach einem der Ansprüche 8 oder 9, dadurch gekennzeichnet, daß das verwendete isolierende Substrat (30) verformbar ist.

**Claims**

**1.** Current sensor or transducer (10) for measuring the current flowing through an electric conductor (11), comprising a magnetoresistive tape (12) surrounding the conductor and whose ends (13, 14) are to be connected to a device for measuring said current, characterized in that the tape is shaped like a tube with an axis centred on the conductor and that it is formed with a multilayer, metallic, magnetic structure, whose layers constitute the same number of stacked elementary tubes concentric to said axis.

**2.** Current sensor according to claim 1, characterized in that the tape has means for the magnetic polarization of the metallic, multilayer, magnetic structure.

**3.** Current sensor according to claim 2, characterized in that the tape has a sequence of metallic, multilayer, magnetic structure elements (31), two successive elements of the sequence being electrically interconnected by magnetic, conductive elements (32) constituting said magnetic polarization means.

**4.** Current sensor according to claim 2, characterized in that the tape has a sequence of metallic, multilayer, magnetic structure elements (41), two successive elements of the sequence being electrically interconnected by conductive elements (43) supporting magnetic elements (42) constituting the said magnetic polarization means.

**5.** Current sensor according to claim 4, characterized in that, in order to reduce the resistance of the magnetoresistive tape due to the conductive elements, the section of said conductive elements, considered in a plane perpendicular to the tape length, exceeds the section, also considered in a plane perpendicular to the tape length, of metallic, multilayer, magnetic structure elements.

**6.** Current sensor according to any one of the claims 2 to 5, characterized in that said magnetic polarization means are produced from a hard, magnetic material.

**7.** Current sensor according to any one of the claims 1 to 6, characterized in that it is constituted by a circular support (61) to which is fixed the magnetoresistive tape (63).

**8.** Process for the production of a current sensor incorporating a magnetoresistive tape having ends for connection to a device for measuring the current, characterized in that it comprises the following stages:

- deposition on one face of an insulating substrate of a conductive, metallic layer,
- etching the conductive, metallic layer to form the ends of the tape,
- deposition of a conductive, magnetic material layer on said face,
- etching said conductive, magnetic material layer to obtain a sequence of aligned, separated, conductive, magnetic elements located between said ends,
- deposition on said face of a metallic, multilayer, magnetic structure layer,
- etching said metallic, multilayer, magnetic structure layer to obtain elements (31) solely between the magnetic elements (32) and so as to ensure the electrical continuity between said ends.

**9.** Process for the production of a current sensor incorporating a magnetoresistive tape having ends to be connected to a device for measuring the current, characterized in that it comprises the following stages:

- deposition on one face of an insulating substrate (40) a conductive, metallic layer,
- etching the conductive, metallic layer to form the ends of the tape and a sequence of aligned, separated, conductive elements (43) between said ends,
- deposition of a magnetic material layer on said face,
- etching said magnetic material layer to obtain a sequence of magnetic elements (42) resting on the conductive elements (43),
- deposition on said face of a metallic, multilayer, magnetic structure layer,
- etching said metallic, multilayer, magnetic structure layer to obtain elements (41) solely between the conductive elements (43) and to ensure the electrical continuity between said ends.

10. Process according to either of the claims 8 and 9, characterized in that the insulating substrate (30) used can be deformed.

FIG. 1

FIG. 2

FIG. 3

FIG. 4

13

FIG. 5

FIG. 6

FIG. 7

FIG. 8

$R(Hpol + H_I)$

$Hpol$

$O$

$H_I$

$H$

$Hpol + H_I$

FIG. 9

FIG. 10

FIG. 11

+V

FIG. 12